# EUROPEAN PATENT SPECIFICATION

(11) **EP 3 201 676 B1**
(45) Date of publication and mention of the grant of the patent: **21.04.2021**
(21) Application number: 15781039.1
(22) Date of filing: 28.09.2015
(51) Int. Cl.: G02B 26/00

(54) **ELECTROWETTING ELEMENT WITH A LAYER INCLUDING SILICON AND FLUORINE**
ELEKTROBENETZUNGSELEMENT MIT EINER SCHICHT MIT SILICIUM UND FLUOR
ÉLÉMENT D'ÉLECTROMOUILLAGE DOTÉ D'UNE COUCHE COMPORTANT DU SILICIUM ET DU FLUOR

(30) Priority: 30.09.2014 US 201414502107
(43) Date of publication of application: 09.08.2017
(73) Proprietor: Amazon Technologies, Inc., Seattle, WA 98108-1226 (US)
(72) Inventor: TAUK, Lara, Seattle, Washington 98109-5210 (US)
(74) Representative: EIP
(86) International application number: PCT/EP2015/072267
(87) International publication number: WO 2016/050694

(56) References cited:
- WO-A1-2013/087858
- WO-A2-2008/146263
- US-A1- 2013 250 396
- US-A1- 2013 329 274
- US-A1- 2014 036 341
- US-A1- 2014 285 869
- YOON S G ET AL: "Characterization of low refractive index SiOCF:H films designed to enhance the efficiency of light emission", JOURNAL OF ELECTROCERAMICS, KLUWER ACADEMIC PUBLISHERS, BO, vol. 16, no. 4, 1 July 2006 (2006-07-01), pages 469-472, XP019450614, ISSN: 1573-8663, DOI: 10.1007/S10832-006-9899-8

## Description

### BACKGROUND

Known electrowetting display devices include two support plates. In examples, a pattern of walls is arranged on one of the support plates, the pattern defining picture elements of the display device. An area defined by the walls of a picture element, also known as a pixel, is called the display area, over which a display effect occurs. The area of the support plate in the display area may be hydrophobic for a proper operation of the picture element.

In known examples, the support plate includes a stack of layers, including an electrode, at least one barrier layer on the electrode and a layer of hydrophobic material on the barrier layer. The hydrophobic material provides the hydrophobic display area and the barrier layer reduces leakage of current through the support plate. For each layer to provide its required properties for operation of the pixel, each layer needs to be of a minimum thickness. US patent publication number 2013/0250396 A1 describes an electrowetting display device which includes a base substrate and a hydrophobic layer disposed on the base substrate and including at least about 49 atomic percent of fluorine atoms in a surface thereof. US patent publication number 2014/0036341 A1 describes an electrowetting display device with a barrier layer disposed on a pixel electrode and a hydrophobic layer disposed on the barrier layer. International patent publication number 2008/146263 A2 describes a bistable electrowetting display picture element with a hydrophobic surface. US patent publication number 2014/0285869 A1 describes an electrowetting display device with an electrode, which is separated from fluids of the electrowetting display device by an electrically insulating cover layer, which may be a hydrophobic layer or an additional insulating layer US2013/329274 A1 describes an electrowetting display including a layer of a material including silicon and fluorine . The use of a SiOCF:H film is disclosed in YOON S G ET AL: "Characterization of low refractive index SiOCF:H films designed to enhance the efficiency of light emission", JOURNAL OF ELECTROCERAMICS, KLUWER ACADEMIC PUBLISHERS, BO, vol. 16, no. 4, 1 July 2006 (2006-07-01), pages 469-472, XP019450614, ISSN: 1573-8663.

It is desirable to reduce a thickness of a support plate in an electrowetting element.

### BRIEF DESCRIPTION OF DRAWINGS

FIG. 1 shows schematically an example electrowetting display element;
FIG. 2 shows schematically a different example electrowetting display element;
FIG. 3 shows a plan view of the example display elements; and
FIG. 4 is a flow diagram showing an example method of manufacture; and
FIG. 5 shows a schematic system diagram of an example apparatus including an electrowetting display device.

### DETAILED DESCRIPTION

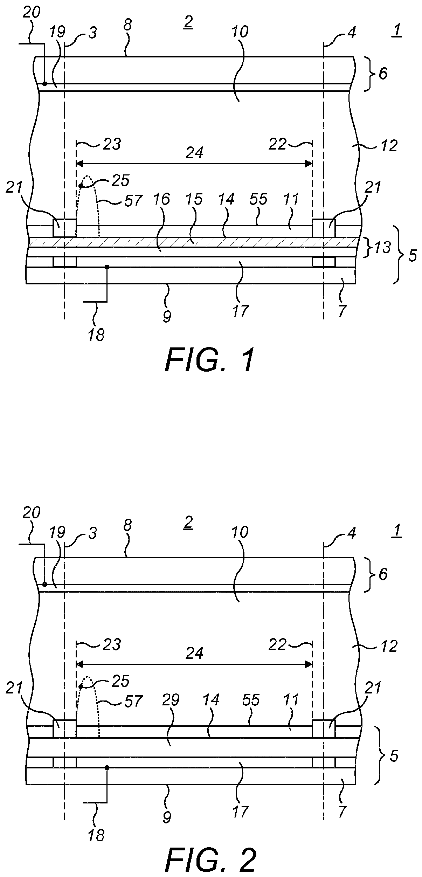

FIG. 1 shows a diagrammatic cross-section of part of an example of an electrowetting display device 1, including a plurality of picture elements or display elements 2, one of which is shown in the Figure and which may also be referred to as an electrowetting pixel. Such a pixel or display element is an example of an electrowetting cell or an electrowetting element, the pixel or display element being an example of an electrowetting element for providing a display effect. The lateral extent of the display element is indicated in the Figure by two dashed lines 3, 4. The display elements comprise a first support plate 5 and a second support plate 6. The support plates may be separate parts of each display element, but the support plates may be shared in common by the plurality of display elements. The support plates may include a glass or polymer substrate 7a, 7b and may be rigid or flexible.

The display device has a viewing side 8 on which an image or display formed by the display device can be viewed and a rear side 9. In the Figure a surface of the first support plate 5, which surface is in this example a surface of the substrate 7a, defines the rear side 9; a surface of the second support plate 6, which surface is in this example a surface of the substrate 7b, defines the viewing side; alternatively, in other examples, a surface of the first support plate may define the viewing side. The display device may be of the reflective, transmissive or transflective type. The display device may be an active matrix driven display device. The plurality of display elements may be monochrome. For a colour display device the display elements may be divided in groups, each group having a different colour; alternatively, an individual display element may be able to show different colours.

A space 10 of each display element between the support plates is filled with two fluids: a first fluid 11 and a second fluid 12 at least one of which may be a liquid. The second fluid is immiscible with the first fluid. Therefore, the first fluid and the second fluid do not substantially mix with each other and in some examples do not mix with each other to any degree. The immiscibility of the first and second fluids is due to the properties of the first and second fluids, for example their chemical compositions; the first and second fluids tend to remain separated from each other, therefore tending not to mix together to form a homogeneous mixture of the first and second fluids. Due to this immiscibility, the first and second fluids meet each other at an interface labelled 55 in FIG. 1 for when no voltage is applied and labelled 57 for when a voltage is applied, which interface defines a boundary between the volume of the first fluid and the volume of the second fluid; this interface or boundary may be referred to as a meniscus. With the first and second fluids substantially not mixing with each other, it is envisaged in some examples that there may be some degree of mixing of the first and second fluids, but that this is considered negligible in that the majority of the volume of first fluid is not mixed with the majority of the volume of the second fluid.

The second fluid is electrically conductive and/or polar and may be water, or a salt solution such as a solution of potassium chloride in water. The second fluid may be transparent; it may instead be coloured, for example, or absorbing. The first fluid, which is electrically non-conductive, may for example be an alkane like decane or hexadecane, silicone oil or decalin (otherwise known as bicyclo-4,4,0-decane).

The first fluid may absorb at least a part of the optical spectrum. The first fluid may be transmissive for a part of the optical spectrum, forming a colour filter. For this purpose the first fluid may be coloured by addition of pigment particles or a dye. Alternatively, the first fluid may be black, i.e. absorb substantially all parts of the optical spectrum, or reflecting. A reflective first fluid may reflect the entire visible spectrum, making the layer appear white, or part of it, making it have a colour.

In examples, for example those described using FIG. 1, the support plate 5 has a surface of an electrowetting element for adjoinment by a fluid such as the first fluid described herein; in the example of FIG. 1 this surface is labelled 14. In some examples, for example those shown in FIG. 1, two layers, namely a first layer 16 and a second layer 15 form what is referred to herein as an insulating layer 13, positioned between an electrode 17 and the space 10, having electrically insulating properties. Thus, the second layer has the surface for adjoinment by the first fluid. The second layer separates the first layer from the first fluid. Such examples may be useful where it is desired to use a fluoropolymer, or other material which is different from the material including silicon and fluorine described herein, for the second layer 15 for adjoining the first fluid, for example due to particular desired properties of the fluoropolymer.

In other examples, for example those described using FIG. 2, the insulating layer is instead an insulating single layer 29 between the electrode and the space, which is referred to in such examples as the first layer 29; thus in such examples the first layer has the surface for adjoinment by the first fluid. Such examples may be useful where, for example, a simpler manufacturing method is required and/or if a thinner support plate is desired and/or if tuning of the wettability of a surface for adjoining the first fluid is required, as described further below. Some features of the examples described using FIG. 2 are the same or similar as in examples described using FIG. 1; such features are labelled with the same reference numbers.

Referring to both FIGs. 1 and 2, the insulating layer 13, 29 may be transparent or reflective. The insulating layer may extend between walls of a display element. To avoid short circuits between the second fluid 12 and electrodes arranged under the insulating layer, parts of the insulating layer may extend uninterrupted over a plurality of display elements 2, as shown in the Figure. The insulating layer has the surface 14 facing, i.e. closest to, the space 10 of the display element 2. The thickness of the insulating layer may be less than 2 micrometers and may be less than 1 micrometer. It is noted that a layer described in examples herein may be at least one film, coating, or covering, which may have a substantially uniform thickness in some examples, i.e. a uniform thickness within accepted manufacturing tolerances, or a variable thickness in other examples.

The insulating layer in some examples, where the insulating layer is a single layer 29, is formed at least partly of a material including silicon and fluorine, as described above and illustrated in FIG. 2. In some such examples the insulating layer 29, i.e. the first layer, is formed solely of the material including silicon and fluorine. Alternatively, in examples where the insulating layer 13 comprises two layers, namely the first layer 16 and the second layer 15, as shown by FIG. 1, the first layer 16 is formed at least partly of the material including silicon and fluorine and in some such examples is formed solely of the material including silicon and fluorine. The second layer 15 is for example formed at least partly of a fluoropolymer such as Teflon® AF1600. Further details of the material including silicon and fluorine will be described further below.

In the absence of an applied voltage, i.e. with the applied voltage being a zero voltage, the first fluid 11 adheres preferentially to the surface of the insulating layer 13 for adjoinment by the first fluid, since the surface for adjoinment by the first fluid has a higher, i.e. greater, wettability for the first fluid than for the second fluid; the surface may therefore be hydrophobic. As will be explained, with the applied voltage being a non-zero voltage, the surface has a lower wettability for the first fluid than for the second fluid; i.e. the surface with the applied non-zero voltage may be considered to be hydrophilic. Wettability relates to the relative affinity of a fluid for the surface of a solid. Wettability may be measured by the contact angle between a boundary of the fluid and the surface of the solid. The contact angle is determined by the difference in surface tension between the fluid and the solid at the fluid-solid boundary. For example, a high difference in surface tension can indicate hydrophobic properties. As the skilled person will appreciate, a material may be considered to be hydrophobic if the contact angle with water is greater than 90 degrees; a material may therefore be considered to be hydrophilic if the contact angle with water is less than 90 degrees.

In the example of FIG. 1, each display element 2 includes a first electrode 17 as part of the support plate 5. The first electrode is used for applying the voltage between the first electrode and the second fluid, as described later. In examples shown there is one such electrode 17 per element. The electrode 17 is electrically insulated from the first and second fluids by the insulating layer 13. Therefore, in some examples where the insulating layer is a single layer 29 as described above and which in such examples is referred to as the first layer, as shown in FIG. 2, a further surface of the first layer adjoins the electrode and the first layer separates the electrode from the first fluid. In other examples described above using FIG. 1 and where the insulating layer comprises two layers, namely the first layer 16 and the second layer 15, with the second layer 15 separating the first layer 16 from the first fluid, a surface of the first layer adjoins the electrode and separates the electrode from the second layer. In further examples it is envisaged that there may be additional layers between the electrode and the surface for adjoinment by the first fluid, than those described in examples herein.

Electrodes of neighbouring display elements are separated by a nonconducting layer. The electrode 17 can be of any desired shape or form. The electrode 17 of a display element is supplied with voltage signals by a signal line 18, schematically indicated in the Figure.

The support plate 6 for example includes a second electrode 19, which may extend between walls of a display element or extend uninterruptedly over a plurality of display elements 2, as shown in the Figure. The electrode 19 is in electrical contact with the second fluid 12 and is common to all display elements. The electrodes 17 and 19 may be made of for example the transparent conductive material indium tin oxide (ITO). A second signal line 20 is connected to the electrode 19. Alternatively, the electrode may be arranged at a border of the support plates, where it is in electrical contact with the second fluid. This electrode may be common to all elements, when they are fluidly interconnected by and share the second fluid, uninterrupted by walls. The display element 2 can be controlled by a voltage V applied between the signal lines 18 and 20. The signal line 18 can be coupled to a matrix of control lines on the substrate 7. The signal line 20 is coupled to a display driving system.

The first fluid 11 in this example is confined to one display element by walls 21 that follow the cross-section of the display element. The cross-section of a display element may have any shape; when the display elements are arranged in a matrix form, the cross-section is usually square or rectangular. Although the walls are shown as structures protruding from the insulating layer 13, 29 and formed on a surface of the insulating layer 13, 29, they may instead be a surface layer of the support plate that repels the first fluid, such as a hydrophilic or less hydrophobic layer. The walls may extend from the first to the second support plate but may instead extend partly from the first support plate to the second support plate as shown in FIG. 1. The extent of the display element, indicated by the dashed lines 3 and 4, is defined by the center of the walls 21. The area of the surface between the walls of a display element, indicated by the dashed lines 22 and 23, is called the display area 24, over which a display effect occurs. The area of the surface on which the walls are formed may be referred to as the wall area. The display effect depends on an extent that the first and second fluids adjoin the surface defined by the display area, in dependence on the magnitude of the applied voltage V described above. The magnitude of the applied voltage V therefore determines the configuration of the first and second fluids within the electrowetting element. In other words, the display effect depends on the configuration of the first and second fluid in the display element, which configuration depends on the magnitude of the voltage applied to the electrodes of the display element. The display effect gives rise to a display state of the display element for an observer looking at the display device. When switching the electrowetting element from one fluid configuration to a different fluid configuration the extent of second fluid adjoining the display area surface may increase or decrease, with the extent of first fluid adjoining the display area surface decreasing or increasing, respectively.

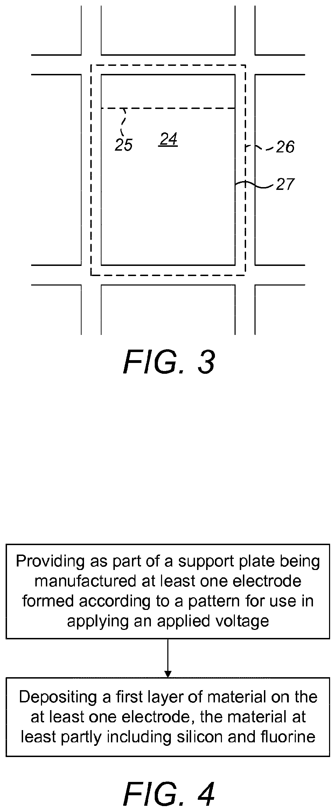

FIG. 3 shows a matrix of rectangular picture elements in a plan view of the hydrophobic surface of the first support plate. The extent of the central picture element in FIG. 3, corresponding to the dashed lines 3 and 4 in FIG. 1 and FIG. 2, is indicated by the dashed line 26. Line 27 indicates the inner border of a wall; the line is also the edge of the display area 23.

When a zero or substantially zero voltage is applied between the electrodes 17 and 19, i.e. when the electrowetting element is in an off state, the first fluid 11 forms a layer between the walls 21, as shown in the FIG. 1. Application of a voltage will contract the first fluid, for example against a wall as shown by the dashed shape 25 in FIG. 1 or FIG. 2. The controllable shape of the first fluid, in dependence on the magnitude of applied voltage, is used to operate the picture element as a light valve, providing a display effect over the display area 23. For example, switching the fluids to increase adjoinment of the second fluid with the display area may increase the brightness of the display effect provided by the element.

This display effect determines the display state an observer will see when looking towards the viewing side of the display device. The display state can be from black to white with any intermediate grey state; in a colour display device, the display state may also include colour.

The material comprising silicon (Si) and fluorine (F) described herein is not known for use in a support plate of an electrowetting element, especially not for example for forming a layer between an electrode and a first fluid, with a surface for adjoinment by the first fluid, for example in accordance with FIGs. 1 and 2. In some examples, the material is a non-polymeric material. A fluoropolymer such as Teflon AF1600 is a polymeric material and is therefore not a non-polymeric material. Non-polymeric for example refers to a material which does not include polymer molecules. A polymer may be considered to be a molecule having at least one backbone of numerous monomer units linked together, as the skilled person will understand. In examples, the material including silicon and fluorine may be a glass; the term glass in examples is considered to be an amorphous solid material; the term amorphous in examples is considered to mean that the material is substantially, i.e. predominantly, non-crystalline, i.e. without crystalline structures of the material. As will be explained below, the properties of such materials are useful for an electrowetting element. Another example of a glass is borosilicate glass, which may be considered for use in an electrowetting element for example instead of the material including silicon and fluorine included herein.

In examples, the material including silicon and fluorine described herein comprises a silicon oxide, which in examples is a material including Si-O bonds. In further examples, the material including silicon and fluorine described herein comprises carbon (C) and a silicon oxide, i.e. a compound of silicon (Si) and oxygen (O) with Si-O bonds, the silicon of the silicon oxide being at least part of the silicon of the material. The material may for example have the formula SiOCF. This formula represents the atoms comprised by the material and not the precise proportions (e.g. number of atoms) of each element, as this depends on the proportion (such as the concentration and/or volume) of reagents used when forming the material, and manufacture conditions, as will be explained in further detail below. The notation SiOCF will be readily understood by the skilled person. In some examples, the SiOCF material comprises a silicon oxide matrix with voids in the matrix occupied with one or more carbon (C) and/or fluorine (F) atoms. In some examples of a SiOCF material, it may be considered that a silicon oxide is doped with C and/or F atoms. It is noted that the material may or may not include hydrogen (H) atoms, depending on the method of forming the material and/or the reagents used to form the material. Therefore, in some examples, the SiOCF material may include H atoms, for example in the form of Si-OH bonds; such a compound may be denoted SiOCF:H.

The material including silicon and fluorine, for example SiOCF, described herein has suitable dielectric properties to function as a dielectric material between the electrode in the support plate and the fluids, which may therefore be considered to provide the insulating properties for the insulating layer, to the extent necessary to allow correct operation of the electrowetting element. In other words, the material may be considered to have a sufficiently low "k" value, which "k" value may be represented instead with the Greek letter kappa as will be appreciated by the skilled person and is known in the art. This dielectric property may be accurately controlled during manufacture, as will be described further below. In examples, the material has a k value between approximately 2 and 3, for between 2 and 3, with a value of for example approximately 2.5, for example 2.5.

Moreover, the material including silicon and fluorine, for example SiOCF, described herein has suitable properties to function as a barrier layer to reduce or prevent current leakage described above. Such a barrier functionality is in examples provided by a sufficient lack of porosity to ion and/or electron flow, such that the material acts as a barrier against current flow through the layer of the material. This may be contrasted with a fluoropolymer such as Teflon AF1600 which has a porosity which allows ion flow therethrough. Hence, in known systems, a separate barrier layer may be necessary in addition to the fluoropolymer layer for adjoinment by the first fluid.

Given these properties of the material including silicon and fluorine, the material such as SiOCF may be used for a barrier layer instead of known materials for a barrier layer which separate a fluoropolymer layer and an electrode. The dielectric properties of the material make it possible to reduce a thickness of the barrier layer and therefore of the support plate compared with known systems. For example the thickness of the layer may be equal to or less than approximately 400 nanometres, for example 400 nanometres; equal to or greater than approximately 300 nanometres, for example 300 nanometres; or a value in the range of approximately 300 to 400 nanometres, for example 300 to 400 nanometres. The term approximately in examples allows for a degree of variation from the values given above, to cover thickness variations within acceptable manufacturing tolerances. With the dielectric and barrier properties of the material, a thinner support plate is feasible compared with known systems. The thickness is in examples taken in a direction perpendicular to the plane of the surface for adjoinment by the first fluid. Thus, the first layer 16 of the insulating layer 13 described above may be formed of such a material including silicon and fluorine such as SiOCF.

The material including silicon and fluorine, for example SiOCF, described herein is in examples more wettable for the first fluid than for the second fluid in the absence of an applied voltage and may therefore be hydrophobic. Thus, a layer of the material including silicon and fluorine may be used to form the surface of the support plate for adjoinment by the first fluid as described herein. Moreover, as explained below, the degree of wettability, for example hydrophobicity, may be selected during manufacture of the material as explained below, allowing accurate control of the wettability properties of the surface for adjoinment by the first fluid. In contrast, in known systems which use a fluoropolymer layer, it may be less simple to control the wettability of the surface for adjoining the first fluid, as this may depend on the already formed polymer molecules before the layer of fluoropolymer is applied using for example a spin coating technique.

The wettability property of the material including silicon and fluorine is useful in an electrowetting element. Given the dielectric and barrier properties of the material in addition, the material including silicon and fluorine, for example SiOCF, may be used to form a single layer, such as the first layer described above where the insulating layer is a single layer 29 as shown in FIG. 2, between the electrode in the support plate and the first fluid, without further layers between the electrode and the first fluid in the space. Thus, it is unnecessary to provide a separate layer of fluoropolymer on the barrier layer compared with known systems. This simplifies manufacture of the electrowetting element compared with known elements, as one layer of the material including silicon and fluorine may be applied on an electrode structure in a single process step, instead of known electrowetting elements requiring more than one process step to form a barrier layer on the electrode and then a fluoropolymer layer. Moreover, given the dielectric properties described above, the single layer may be thinner compared with known insulating layers. For example, the thickness of the single layer, referred to otherwise as the first layer, may be equal to or less than approximately 400 nanometres, for example 400 nanometres; equal to or greater than approximately 300 nanometres, for example 300 nanometres; or a value in the range of approximately 300 to 400 nanometres, for example 300 to 400 nanometres. The term approximately as explained above allows for a degree of variation in examples from the values given above, to cover thickness variations within acceptable manufacturing tolerances. Thus, for a single layer between the electrode and the first fluid, a thinner support plate is conceivable compared with known systems, particularly as in some examples no fluoropolymer layer is required.

With such a reduced thickness layer compared with known systems, as a result for example of the dielectric properties of the material including silicon and fluorine, a reduced magnitude of applied voltage may be needed to obtain the same fluid configuration when compared with known systems. Thus, using the material including silicon and fluorine to reduce the thickness of such a layer allows in examples an electrowetting element to be constructed which has lower power requirements compared with known devices.

Selecting a material for use in an electrowetting element is not trivial. The requirements are numerous and complex. As well as the properties of the material including silicon and fluorine, for example SiOCF, described above for use in an electrowetting element, the material including silicon and fluorine has further properties which yet further make it suitable for use in examples of an electrowetting element.

One such property is a mechanical strength of the material, such as SiOCF. The material may for example have a hardness value of approximately 2 gigapascals (GPa), for example 2 GPa, when measured using a suitable hardness test, which is well known to the skilled person. The material for example has a Young's modulus of approximately 21 GPa, for example 21 GPa. The term approximately allows for a degree of variation within acceptable tolerances for the material to provide the required function in the electrowetting element, for example any of: structural support, cohesive strength within the layer, suitable adhesion with adjacent layers, resistance to thermal and chemical stress, or resistance against delamination, i.e. at least partial separation, of the layer from adjacent layers such as the electrode, for example when the electrowetting element is exposed to thermal stress. Despite the hardness of the material, the material may be formed as a layer of a support plate suitable for manufacturing an electrowetting display device using a roll-to-roll processing technique. Therefore, such a support plate may be sufficiently flexible for the roll-to-roll processing and may be sufficiently flexible for a flexible, e.g. bendable, display device.

Another such property is the refractive index of the material, for example SiOCF. The refractive index can be controlled during manufacture of the first layer using the radiofrequency power, as described below. The refractive index may for example be one or more of: approximately 1.3 to 1.5, for example 1.3 to 1.5; approximately 1.35 to 1.45, for example 1.35 to 1.45; or approximately 1.4, for example 1.4. The term approximately allows for a degree of variation within acceptable tolerances for the material to provide the required function in the electrowetting element, for example a suitable refractive index. The refractive index of the material may for example be the same as, or acceptably close in value to a refractive index of the first and/or the second fluids. Therefore, in examples where the first layer is formed at least partly of the material including silicon and fluorine, the surface for adjoinment with the first fluid may be substantially invisible (i.e. there is no appreciable effect for the functioning of the electrowetting element) to any first and second fluid adjoining the surface. This is because there is no significant change in refractive index at the surface between the first layer and the first and/or second fluids. Therefore, any refraction at the surface is reduced or minimised. This gives improved optical properties including an improved quality of a display effect compared with known systems. For example, the material including silicon and fluorine has a refractive index equal to or less than 10%, 7%, 5%, 3%, or 1% different from a refractive index of at least one of the first fluid or the second fluid. For example, the second fluid has a refractive index of approximately 1.45, for example 1.45 and the refractive index of the material is approximately 1.33, for example 1.33. This corresponds with a difference of 8.28% (i.e. (1.45-1.33)/1.45 x 100) of the refractive index of the material from the refractive index of the second fluid.

A further such property is the optical transparency of the material, such as SiOCF. The material in examples transmits more than 90%, for example more than 95%, more than 97% or more than 99% of light in the visible spectrum which is incident on the material. In this way, the material including silicon and fluorine transmits substantially a majority, for example substantially all, visible light incident on the material. This helps to provide an efficient electrowetting element in terms of visible light transmission of light emitted by for example a backlight. This can improve the brightness of a display effect for a given light output of a backlight, compared with known systems. Moreover, as the material transmits substantially a majority of visible light, the material may not change a colour of light passing through the first layer, i.e. there may be substantially no change in the colour point of transmitted light, which may otherwise affect the quality of the display effect. Due to these transmission properties, the material has low reflective qualities, which again may help to provide a display effect of suitable quality, as there may be no or minimal reflections which could interfere with the display effect.

An example of a method of manufacturing a support plate for at least one electrowetting element will now be described with reference to features of FIGS. 1, 2, 3 and also to FIG. 4. During the manufacturing process of the electrowetting element, for example of a display device, the first support plate may be manufactured entirely, or may be provided during the manufacturing process as a partly or completely assembled support plate. When manufacturing the first support plate according to an example the substrate 7a is provided. An electrode layer comprising at least one electrode 17, corresponding to the first electrode described above, is provided on the substrate 7a, for example with further layers between the first electrode and the substrate 7a. A material for forming, for example depositing, the at least one electrode is provided on a surface for example that of the substrate and the material is patterned for forming the at least one electrode according to a desired pattern. Where the first electrode material is for example ITO, a plasma enhanced chemical vapour deposition technique or a DC (direct current) magnetron sputtering technique may be used, as the skilled person would know.

In this way, according to examples described herein and in further envisaged examples, a structure is provided which is for example the first electrode. A first layer is then formed on the structure. In some examples, this first layer is the single layer 29 described in examples above, which single layer separates the electrode from the first fluid; in other examples, this first layer 16 will separate the electrode from a second layer which will be formed on the first layer, as described in examples above and which will be described further below.

The first layer is formed on the structure and at least partly comprises a material including silicon and fluorine in accordance with examples described above. For example the material may be SiOCF. In some examples, the first layer is entirely formed of the material such as SiOCF. In an example, the first layer is formed at least partly of the material using a chemical vapour deposition (CVD) process which will is well known to the person skilled in the art. The CVD process may for example be a plasma enhanced CVD process (PECVD), again as is well known in the art.

In an example, SiOCF may be deposited to form the first layer using a PECVD process with a mixture of silane (SiH₄), tetrafluoromethane (CF₄) and nitrous oxide (N₂O) precursor gases with suitable carrier gases. More specifically, in the PECVD process, the mixture of gases is exposed to a radiofrequency which causes ionisation of the gases and subsequent deposition of a solid layer formed from the ionised precursor gases. The precise structure of the material forming the film, including for example the arrangement of atoms in the material, the types of bonds and the proportion of each type of atom, will depend on the proportion of each precursor gas in the mixture, the precursor gases and process conditions and parameters, for example the frequency and power of the radiofrequency, pressure and temperature conditions, as the skilled person will understand.

For example, a CVD process such as a PECVD process may include controlling a radiofrequency power to select a proportion of fluorine in the resulting material including silicon and fluorine, for example SiOCF. By tuning the process to select a desired proportion of fluorine in the material, a wettability of the material for the first fluid and the second fluid may be accurately controlled and selected specifically in accordance with the specifications of the electrowetting element being manufactured. Further, by controlling the proportion of fluorine in this way, other properties of the material may be controlled, for example one or more of a refractive index, a hardness or a dielectric constant. It is noted that although controlling the radiofrequency power may influence the proportion of fluorine in the material, this controlling may also influence the proportion of carbon, silicon and/or oxygen in the material.

In examples where the first layer is a single layer 29 between the electrode and the first fluid in the space of the electrowetting element to be manufactured, the next step in manufacturing the support plate may be to form walls on the first layer. Thus, a simple manufacturing method is available in some examples for providing the support plate with the required dielectric, wettability and barrier properties, as only a single layer need to be formed on the electrode in such examples, rather than multiple layers. In other examples, where the first layer is separated from the first fluid by a second layer 15, the next step may be to form the second layer on the first layer; if the second layer is formed of a fluoropolymer such as Teflon AF1600, a spin coating technique may be used, for example, as will be readily understood by the skilled person. Then, walls may be formed on the second layer.

Regardless of whether the walls are to be formed on the first layer (i.e. where the first layer is a single layer between the electrode and the first fluid), or on the second layer, the same technique may be used for forming the walls. In an example, the walls are formed by first treating the surface on which the walls are to be formed using a reactive ion etching (RIE) process to increase a wettability of the surface for the walls to be formed. Then a photolithography technique may be used to apply a material for forming the walls for example a SU8 photoresist material, which would be well known to the skilled person. More specifically, a wall material may be spread across at least part of the surface of the layer on which the walls are to be formed and then patterned using for example photolithography with ultraviolet light applied selectively, using a mask, to the applied wall material. After then hard baking the patterned wall material, the patterned wall material is developed, leaving the formed walls, using an appropriate masking and development technique, as the skilled person will understand. Once the walls are formed, it may then be necessary in examples to increase the hydrophobicity of the surface for the display area, given the previous RIE treatment.

Once the first support plate is manufactured it may be assembled with a pre-manufactured second support plate, to assemble one or more electrowetting elements by attaching the first and second support plates together, for example using an adhesive seal at an outermost perimeter of an array of the one or more electrowetting elements, after having provided the first and second fluids in the space to be formed between the first and second support plates. The skilled person will readily appreciate suitable techniques for this.

It is to be noted that the phrase "wall material" is used to cover a material from which at least one wall is to be formed, for example a pre-cursor wall material, a material which forms at least one wall after a wall formation process and any intermediate material formed during formation of at least one wall. It is also to be appreciated that in further examples, other manufacturing methods may be used to manufacture the first support plate.

The above examples are to be understood as illustrative examples. Further examples are envisaged. For example, although examples are described above in relation to a display element, it is envisaged that a layer of the material including silicon and fluorine described in examples above may be used in other types of electrowetting devices. Moreover, although a layer of a support plate has been described which is at least partly formed of the material including silicon and fluorine, further examples are envisaged where other parts of an electrowetting device may be at least partly formed of the material including silicon and fluorine in order to provide at least some of the properties described. Moreover, examples described herein are not intending to be limiting; further examples are envisaged than those described herein, with an electrowetting element comprising a support plate having a surface for adjoinment by a first fluid, with the support plate including a first layer at least partly formed of a material including silicon and fluorine in accordance with any examples of the material including silicon and fluorine described above.

Further, for examples described above which for example include only a first layer and a second layer between the electrode and the first fluid in the space of the electrowetting element, in further examples there may be more than two layers between the electrode and the first fluid. Further, where in some examples described herein a layer is described as being formed on, so as to contact, a structure or another layer, further examples are envisaged where the term "on" may be considered to mean supported by and not contacting an underlying layer; for example there may be an intermediate layer between an electrode structure and the first layer formed of the material.

In further examples, different from those described previously, the insulating layer may comprise two layers with a first layer being at least partially formed of an example of the material described herein and providing a surface for adjoinment by the first fluid, which first layer is for separating the first fluid in a cavity of the display element and a barrier layer formed on an electrode. In other words, a fluoropolymer layer of for example AF1600® of a known electrowetting display element may instead be formed of an example of the material described herein, which layer of material is formed on a barrier layer of for example silicon oxide or silicon nitride, for reducing current leakage, which barrier layer may in turn be formed on an underlying electrode.

Examples have been described using a PECVD process for forming the first layer. Further details of examples of PECVD processes which may be used in depositing a layer of the material are available from the following references: Electroceram (2006) 16:469-472, Yoon *et al.;* and J. Phys. D: Appl. Phys. 34 (2001) 155-159, Shi-Jin Ding et al*.* In further examples, it is envisaged that other processes may be used for forming the layer at least partly of the material, for example plasma assisted CVD (PACVD), high vacuum CVD (HVCVD), atomic layer deposition (ALD) or sol-gel processing.

Examples of the material including silicon and fluorine are described herein which include SiOCF. It is envisaged in further examples that the material may include, for example be at least partially formed of, other materials including silicon and fluorine. Such other materials include SiOF, which is similar to SiOCF but without carbon atoms; in other examples the material may include silicon, fluorine and nitrogen (N) in the form SiNF, with Si-N bonds. In further examples the material may include SiONF, with Si-O bonds and nitrogen and fluorine, for example including Si-N bonds.

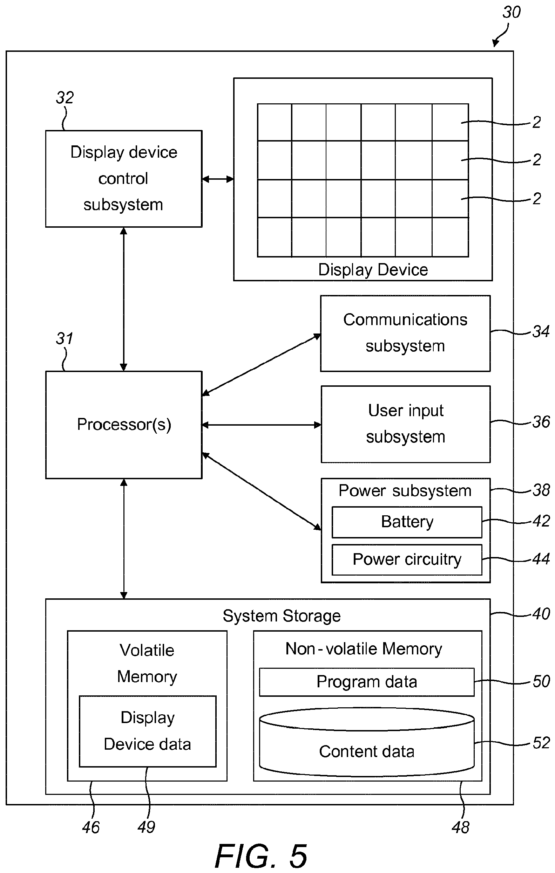

FIG. 5 shows schematically a system diagram of an example system, for example apparatus 130, comprising an electrowetting display device such as the electrowetting display device 1 described above comprising electrowetting display elements 2. The apparatus is for example a portable, i.e. mobile, device such as an electronic reader device such as a so-called "e-reader", a tablet computing device, a laptop computing device, a mobile telecommunications device, a watch or a satellite navigation device; the apparatus may alternatively be a display screen for installation in any machine or device requiring a display screen, for example a consumer appliance.

The system diagram illustrates an example of a basic hardware architecture of the apparatus 130. The apparatus includes at least one processor 131 connected to and therefore in data communication with for example: a display device control subsystem 132, a communications subsystem 134, a user input subsystem 136, a power subsystem 138 and system storage 140. The display device control subsystem is connected to and is therefore in data communication with the display device 1.The at least one processor 131 is for example a general purpose processor, a microprocessor, a digital signal processor (DSP), an application specific integrated circuit (ASIC), a field programmable gate array (FPGA) or other programmable logic device, a discrete gate or transistor logic, discrete hardware components, or any suitable combination thereof designed to perform the functions described herein. A processor may also be implemented as a combination of computing devices, e.g., a combination of a DSP and a microprocessor, a plurality of microprocessors, one or more microprocessors in conjunction with a DSP core, or any other such configuration. The processor may be coupled, via one or more buses, to read information from or write information to one or more memories, for example those of the system storage 140. The at least one processor may additionally, or in the alternative, contain memory, such as processor registers.

The display device control subsystem 132 for example includes electrowetting display element driver components, for use in applying a voltage to any of the electrowetting display elements, to address different such display elements. In examples the electrowetting display elements are configured according to an active matrix configuration and the display device control subsystem is configured to control switching elements such as thin film transistors (TFTs) of the display device 1 via circuitry to control the electrowetting display elements. The circuitry may include signal and control lines such as those described above.

The communications subsystem 134 for example is configured for the apparatus to communicate with for example a computing device via a data network, for example a computer network such as the Internet, a local area network, a wide area network, a telecommunications network, a wired network, a wireless network, or some other type of network. The communications subsystem 134 may further for example comprise an input/output (I/O) interface, such as a universal serial bus (USB) connection, a Bluetooth or infrared connection, or a data network interface for connecting the apparatus to a data network such as any of those described above. Content data as described later may be transferred to the apparatus via the communications subsystem.

The user input subsystem 136 may include for example an input device for receiving input from a user of the apparatus. Example input devices include, but are not limited to, a keyboard, a rollerball, buttons, keys, switches, a pointing device, a mouse, a joystick, a remote control, an infrared detector, a voice recognition system, a bar code reader, a scanner, a video camera (possibly coupled with video processing software to, e.g., detect hand gestures or facial gestures), a motion detector, a microphone (possibly coupled to audio processing software to, e.g., detect voice commands), or other device capable of transmitting information from a user to the device. The input device may also take the form of a touch-screen associated with the display device, in which case a user responds to prompts on the display device by touch. The user may enter textual information through the input device such as the keyboard or the touch-screen.

The apparatus may also include a user output subsystem (not illustrated) including for example an output device for providing output to a user of the apparatus. Examples include, but are not limited to, a printing device, an audio output device including for example one or more speakers, headphones, earphones, alarms, or haptic output devices. The output device may be a connector port for connecting to one of the other output devices described, such as earphones.

The power subsystem 138 for example includes power circuitry 144 for use in transferring and controlling power consumed by the apparatus. The power may be provided by a mains electricity supply or from a battery 142, via the power circuitry. The power circuitry may further be used for charging the battery from a mains electricity supply.

The system storage 140 includes at least one memory, for example at least one of volatile memory 146 and non-volatile memory 148 and may comprise a non-transistory computer readable storage medium. The volatile memory may for example be a Random Access Memory (RAM). The non-volatile (NV) memory may for example be a solid state drive (SSD) such as Flash memory, or Read Only Memory (ROM). Further storage technologies may be used, for example magnetic, optical or tape media, compact disc (CD), digital versatile disc (DVD), Blu-ray or other data storage media. The volatile and/or non-volatile memory may be removable or non-removable.

Any of the memories may store data for controlling the apparatus, for example components or subsystems of the apparatus. Such data may for example be in the form of computer readable and/or executable instructions, i.e. computer program instructions. Therefore, the at least one memory and the computer program instructions may be configured to, with the at least one processor, control a display effect provided by the electrowetting display device.

In the example of FIG. 5, the volatile memory 146 stores for example display device data 149 which is indicative of display effects to be provided by the display device 1. The processor 131 may transmit data, based on the display device data, to the display device control subsystem 132 which in turn outputs signals to the display device for applying voltages to the display elements, for providing display effects from the display device. The non-volatile memory 148 stores for example program data 150 and/or content data 152. The program data is for example data representing computer executable instructions, for example in the form of computer software, for the apparatus to run applications or program modules for the apparatus or components or subsystems of the apparatus to perform certain functions or tasks, and/or for controlling components or subsystems of the apparatus. For example, application or program module data includes any of routines, programs, objects, components, data structures or similar. The content data is for example data representing content for example for a user; such content may represent any form of media, for example text, at least one image or a part thereof, at least one video or a part thereof, at least one sound or music or a part thereof. Data representing an image or a part thereof is for example representative of a display effect to be provided by at least one electrowetting element of the electrowetting display device. The content data may include data representing a library of content, for example a library of any of books, periodicals, newspapers, movies, videos, music, or podcasts, each of which may be represented by a collection of data which represents for example one book or one movie. Such a collection of data may include content data of one type, but may instead include a mixture of content data of different types, for example a movie may be represented by data including at least image data and sound data.

Further examples are envisaged.

It is to be understood that any feature described in relation to any one example may be used alone, or in combination with other features described, and may also be used in combination with one or more features of any other of the examples, or any combination of any other of the examples. Furthermore, equivalents and modifications not described above may also be employed without departing from the scope of the accompanying claims.

## Claims

1. An electrowetting element comprising:
a first fluid;
a second fluid immiscible with the first fluid, a configuration of the first fluid and the second fluid controllable with an applied voltage;
at least one electrode for providing the applied voltage; anc **characterized by**
a support plate having a surface for adjoinment by the first fluid, wherein the support plate includes a first layer comprising a material with the formula SiOCF, the material comprising hydrogen atoms.

2. An electrowetting element according to claim 1, wherein the material is at least one of: a glass or non-polymeric.

3. An electrowetting element according to claim 1, wherein
the first layer has the surface for adjoinment by the first fluid; and
with the applied voltage being a zero voltage, the surface has a greater wettability for the first fluid than for the second fluid, and
with the applied voltage being a non-zero voltage, the surface has a lower wettability for the first fluid than for the second fluid.

4. An electrowetting element according to claim 1, wherein
the support plate comprises an electrode of the at least one electrode for use in applying the applied voltage between the electrode and the second fluid;
the first layer has the surface for adjoinment by the first fluid; and
a further surface of the first layer adjoins the electrode, the first layer separating the electrode from the first fluid.

5. An electrowetting element according to claim 1, wherein the support plate comprises a second layer, the second layer having the surface for adjoinment by the first fluid, wherein the second layer separates the first layer from the first fluid.

6. An electrowetting element according to claim 5, wherein, with the applied voltage being a zero voltage, the surface has a greater wettability for the first fluid than for the second fluid, and
with the applied voltage being a non-zero voltage, the surface has a lower wettability for the first fluid than for the second fluid.

7. An electrowetting element according to claim 5, wherein the support plate comprises an electrode of the at least one electrode for use in applying the applied voltage between the electrode and the second fluid, wherein a surface of the first layer adjoins the electrode, and the first layer separates the electrode from the second layer.

8. An electrowetting element according to claim 5, wherein the second layer comprises a fluoropolymer.

9. An electrowetting element according to claim 1, wherein the material has a refractive index of one or more of: approximately 1.3 to 1.5, approximately 1.35 to 1.45, or approximately 1.4.

10. An electrowetting element according to claim 1, wherein the material has a refractive index equal to or less than 10% different from a refractive index of at least one of the first fluid or the second fluid.

11. A method of manufacturing a support plate for an electrowetting element comprising a first fluid and a second fluid immiscible with the first fluid, a configuration of the first fluid and the second fluid controllable with an applied voltage, the method comprising:
providing, as part of the support plate being manufactured, at least one electrode with a pattern for use in applying the applied voltage; and
depositing a first layer on the at least one electrode, the first layer comprising a material with the formula SiOCF, the material comprising hydrogen atoms.

12. A method according to claim 11, wherein the depositing the first layer includes using a chemical vapour deposition process.

13. A method according to claim 12, wherein the chemical vapour deposition process includes controlling a radiofrequency power to select a proportion of fluorine in the material.

14. A method according to claim 12, wherein the chemical vapour deposition process includes controlling at least one parameter of: a temperature or a radiofrequency power to select at least one of: a refractive index, a hardness or a dielectric constant of the material.

15. A method according to claim 11, wherein the depositing the first layer of material includes forming a surface of the first layer for adjoinment by the first fluid of the electrowetting element.

## Patentansprüche

1. Elektrobenetzungselement, Folgendes umfassend:
ein erstes Fluid;
ein zweites Fluid, das mit dem ersten Fluid nicht mischbar ist,
wobei eine Konfiguration des ersten Fluids und des zweiten Fluids mit einer angelegten Spannung steuerbar ist;
mindestens eine Elektrode zum Bereitstellen der angelegten Spannung; und
**gekennzeichnet durch**
eine Trägerplatte, die eine Oberfläche aufweist, die an das erste Fluid angrenzt, wobei die Trägerplatte eine erste Schicht beinhaltet, die eine Material mit der Formel SiOCF umfasst, wobei das Material Wasserstoffatome umfasst.

2. Elektrobenetzungselement nach Anspruch 1, wobei das Material mindestens eines von Folgendem ist: ein Glas oder nichtpolymer.

3. Elektrobenetzungselement nach Anspruch 1, wobei die erste Schicht die Oberfläche aufweist, die an das erste Fluid angrenzt; und
wenn die angelegte Spannung eine Nullspannung ist, die Oberfläche für das erste Fluid eine größere Benetzbarkeit aufweist als für das zweite Fluid, und
wenn die angelegte Spannung keine Nullspannung ist, die Oberfläche für das erste Fluid eine geringere Benetzbarkeit aufweist als für das zweite Fluid.

4. Elektrobenetzungselement nach Anspruch 1, wobei
die Trägerplatte eine Elektrode der mindestens einen Elektrode umfasst, die zum Anlegen der angelegten Spannung zwischen der Elektrode und dem zweiten Fluid verwendet wird;
die erste Schicht die Oberfläche aufweist, die an das erste Fluid angrenzt; und
eine weitere Oberfläche der ersten Schicht an die Elektrode angrenzt, wobei die erste Schicht die Elektrode von dem ersten Fluid trennt.

5. Elektrobenetzungselement nach Anspruch 1, wobei die Trägerplatte eine zweite Schicht umfasst, wobei die zweite Schicht die Oberfläche aufweist, die an das erste Fluid angrenzt, wobei die zweite Schicht die erste Schicht von dem ersten Fluid trennt.

6. Elektrobenetzungselement nach Anspruch 5, wobei, wenn die angelegte Spannung eine Nullspannung ist, die Oberfläche für das erste Fluid eine größere Benetzbarkeit aufweist als für das zweite Fluid, und
wenn die angelegte Spannung keine Nullspannung ist, die Oberfläche für das erste Fluid eine geringere Benetzbarkeit aufweist als für das zweite Fluid.

7. Elektrobenetzungselement nach Anspruch 5, wobei die Trägerplatte eine Elektrode der mindestens einen Elektrode umfasst, die zum Anlegen der angelegten Spannung zwischen der Elektrode und dem zweiten Fluid verwendet wird, wobei eine Oberfläche der ersten Schicht an die Elektrode angrenzt und die erste Schicht die Elektrode von der zweiten Schicht trennt.

8. Elektrobenetzungselement nach Anspruch 5, wobei die zweite Schicht ein Fluorpolymer umfasst.

9. Elektrobenetzungselement nach Anspruch 1, wobei das Material einen Brechungsindex aufweist, der eines oder mehrere von Folgendem beträgt: ungefähr 1,3 bis 1,5, ungefähr 1,35 bis 1,45 oder ungefähr 1,4.

10. Elektrobenetzungselement nach Anspruch 1, wobei das Material einen Brechungsindex aufweist, der sich um 10 % oder weniger von einem Brechungsindex von mindestens einem von dem ersten Fluid oder dem zweiten Fluid unterscheidet.

11. Verfahren zum Herstellen einer Trägerplatte für ein Elektrobenetzungselement, ein erstes Fluid und ein zweites Fluid, das mit dem ersten Fluid nicht mischbar ist, umfassend, wobei eine Konfiguration des ersten Fluids und des zweiten Fluids mit einer angelegten Spannung steuerbar ist, wobei das Verfahren Folgendes umfasst:
Bereitstellen, als Teil der Trägerplatte, die hergestellt wird, von mindestens einer Elektrode mit einem Muster zum Verwenden beim Anlegen der angelegten Spannung; und
Auftragen einer ersten Schicht auf der mindestens einen Elektrode, wobei die erste Schicht ein Material mit der Formel SiOCF umfasst und das Material Wasserstoffatome umfasst.

12. Verfahren nach Anspruch 11, wobei das Auftragen der ersten Schicht ein Verwenden eines chemischen Dampfabscheideprozesses beinhaltet.

13. Verfahren nach Anspruch 12, wobei der chemische Dampfabscheideprozess ein Steuern einer Funkfrequenzleistung beinhaltet, um einen Anteil von Fluor in dem Material auszuwählen.

14. Verfahren nach Anspruch 12, wobei der chemische Dampfabscheideprozess ein Steuern von mindestens einem der folgenden Parameter beinhaltet: einer Temperatur oder einer Funkfrequenzleistung, um mindestens eines von Folgendem auszuwählen: einen Brechungsindex, eine Härte oder eine Dielektrizitätskonstante des Materials.

15. Verfahren nach Anspruch 11, wobei das Auftragen der ersten Schicht Material beinhaltet, dass eine Oberfläche der ersten Schicht gebildet wird, die an das erste Fluid des Elektrobenetzungselements angrenzt.

## Revendications

1. Élément d'électromouillage comprenant :
un premier fluide ;
un second fluide non miscible avec le premier fluide, une configuration du premier fluide et du second fluide pouvant être commandée avec une tension appliquée ;
au moins une électrode pour fournir la tension appliquée ; et
**caractérisé par**
une plaque de support ayant une surface pour être adjacente au premier fluide, dans lequel la plaque de support comporte une première couche comprenant un matériau de formule SiOCF, le matériau comprenant des atomes d'hydrogène.

2. Elément d'électromouillage selon la revendication 1, dans lequel le matériau est au moins l'un parmi : un verre ou un non-polymère.

3. Élément d'électromouillage selon la revendication 1, dans lequel
la première couche a la surface pour être adjacente au premier fluide ; et
la tension appliquée étant une tension nulle, la surface a une mouillabilité plus grande pour le premier fluide que pour le second fluide, et
la tension appliquée étant une tension non nulle, la surface a une mouillabilité plus faible pour le premier fluide que pour le second fluide.

4. Elément d'électromouillage selon la revendication 1, dans lequel
la plaque de support comprend une électrode de l'au moins une électrode destinée à être utilisée pour appliquer la tension appliquée entre l'électrode et le second fluide ;
la première couche a la surface pour être adjacente au premier fluide ; et
une autre surface de la première couche est adjacente à l'électrode, la première couche séparant l'électrode du premier fluide.

5. Elément d'électromouillage selon la revendication 1, dans lequel la plaque de support comprend une seconde couche, la seconde couche ayant la surface pour être adjacente au premier fluide, dans lequel la seconde couche sépare la première couche du premier fluide.

6. Elément d'électromouillage selon la revendication 5, dans lequel, la tension appliquée étant une tension nulle, la surface a une mouillabilité plus grande pour le premier fluide que pour le second fluide, et
la tension appliquée étant une tension non nulle, la surface a une mouillabilité plus faible pour le premier fluide que pour le second fluide.

7. Elément d'électromouillage selon la revendication 5, dans lequel la plaque de support comprend une électrode de l'au moins une électrode destinée à être utilisée pour appliquer la tension appliquée entre l'électrode et le second fluide, dans lequel une surface de la première couche est adjacente à l'électrode et la première couche sépare l'électrode de la seconde couche.

8. Elément d'électromouillage selon la revendication 5, dans lequel la seconde couche comprend un fluoropolymère.

9. Elément d'électromouillage selon la revendication 1, dans lequel le matériau a un indice de réfraction d'un ou de plusieurs parmi : environ 1,3 à 1,5, environ 1,35 à 1,45 ou environ 1,4.

10. Elément d'électromouillage selon la revendication 1, dans lequel le matériau a un indice de réfraction égal ou inférieur à 10 % différent d'un indice de réfraction d'au moins l'un du premier fluide ou du second fluide.

11. Procédé de fabrication d'une plaque de support pour un élément d'électromouillage comprenant un premier fluide et un second fluide non miscible avec le premier fluide, une configuration du premier fluide et du second fluide pouvant être commandée avec une tension appliquée, le procédé comprenant :
la fourniture, en tant que partie de la plaque de support en cours de fabrication, d'au moins une électrode avec un motif destinée à être utilisée pour appliquer la tension appliquée ; et
le dépôt d'une première couche sur l'au moins une électrode, la première couche comprenant un matériau de formule SiOCF, le matériau comprenant des atomes d'hydrogène.

12. Procédé selon la revendication 11, dans lequel le dépôt de la première couche comporte l'utilisation d'un processus de dépôt chimique en phase vapeur.

13. Procédé selon la revendication 12, dans lequel le processus de dépôt chimique en phase vapeur comporte la commande d'une puissance radiofréquence pour sélectionner une proportion de fluor dans le matériau.

14. Procédé selon la revendication 12, dans lequel le processus de dépôt chimique en phase vapeur comporte la commande d'au moins un paramètre : d'une température ou d'une puissance radiofréquence pour sélectionner au moins l'un parmi : un indice de réfraction, une dureté ou une constante diélectrique du matériau.

15. Procédé selon la revendication 11, dans lequel le dépôt de la première couche de matériau comporte la formation d'une surface de la première couche pour être adjacente au premier fluide de l'élément d'électromouillage.
